Europäisches Patentamt

(19) European Patent Office

Office européen des brevets

(11) Publication number: **0 091 831**
**B1**

# EUROPEAN PATENT SPECIFICATION

(45) Date of publication of patent specification: **03.01.90**

(21) Application number: **83302074.6**

(22) Date of filing: **13.04.83**

(51) Int. Cl.⁵: **H 01 L 29/80, H 01 L 29/36**

(54) Mobility-modulation field effect transistor.

(30) Priority: **14.04.82 JP 62175/82**

(43) Date of publication of application:
**19.10.83 Bulletin 83/42**

(45) Publication of the grant of the patent:
**03.01.90 Bulletin 90/01**

(84) Designated Contracting States:
**DE FR GB NL**

(56) References cited:
**EP-A-0 029 481**
**FR-A-1 418 613**
**US-A-4 257 055**

**APPLIED PHYSICS LETTERS, vol. 39, no. 6,
September 1981, pages 493-495, American
Institute of Physics, New York, US; H.L.
STÖRMER et al.: "Backside-gated modulation-
doped GaAs-(AlGa)As heterojunction interface"
Idem**

(73) Proprietor: **Sakaki, Hiroyuki
174-260 Ohba-cho Midori-ku
Yokohama-shi Kanagawa-ken (JP)**

(72) Inventor: **Sakaki, Hiroyuki
174-260 Ohba-cho Midori-ku
Yokohama-shi Kanagawa-ken (JP)**

(74) Representative: **Rackham, Stephen Neil et al
GILL JENNINGS & EVERY 53-64 Chancery Lane
London WC2A 1HN (GB)**

## Description

The present invention relates to field effect transistors (FETs) in which the electric conductivity of a semiconductor channel is controlled by a voltage applied from outside that channel.

In general, field effect transistors (hereinafter called FETs) are widely used and are one of the most important devices in both discrete and integrated circuits because of their excellence in switching and amplifying functions and their simplicity of construction. Conventionally a FET has a source and a drain with conduction channel means for carrying charge carriers extending between them, and gate electrode means. The operating principle of conventional FETs is to modulate the density of charge carriers travelling within the conduction channel means to conduct electricity through the channel in dependence upon a signal voltage applied to the gate electrode means thereby to control the electric conductivity between the source and the drain. Generally, the channel transit time of charge carriers, that is the time $\tau_t$ required for the charge carriers to travel between the source and the drain, is equal to the channel length L divided by the carrier velocity v, that is the value L/v. Since the charge carriers within the channels are supplied from the source electrode and the drain electrode on opposite ends of the conduction channel, it is required for full accomplishment of modulation of the charge carriers that the minimum change time of the signal voltage applied to the gate electrode is substantially equal to the order of the channel transit time of the carriers. To reduce the response time of the FET, accordingly, it is essential to increase the carrier velocity v while reducing the channel length L. However, even in high speed device such as a gallium arsenide Schottky field-effect transistor known as a GaAsMESFET the ultimate limit of the channel transit time $\tau_t$ of the charge carriers is of the order of 1 picosecond ($10^{-12}$ second) because the maximum carrier velocity is of the order of $2 \times 10^7$ cm/s and the minimum channel length is of the order of 0.2 μm.

Applied Physics Letters, Vol. 39, No. 6, September 1981 at pages 493—495 describes the constructon of an FET with a single conduction channel formed by a GaAs—AlGaAs heterojunction interface. With changes in the voltage applied to an additional backside gate electrode the mobility of charge carriers introduced into the single conduction channel can be further enhanced. However, again in this example it is necessary to charge and discharge charge carriers from the single conduction channel at the time of modulation. Thus in conventional FETs, using charge carrier density modulation, it is impossible in principle to make the response speed 1 picosecond or lower.

Accordingly, conventional FETs have a disadvantage that the carrier density modulation within the channel is not performed sufficiently rapidly to enable it to handle an electric signal changing in a time period shorter than the minimum time required to increase or decrease the charge carrier density within the conductivity channel.

According to this invention in a mobility-modulation field effect transistor the conduction channel means has a multilayer structure formed from a plurality of semiconductor materials and including a plurality of channels, the plurality of channels having different carrier mobilities and comprising a first channel having less impurities than a second channel, accordingly the first channel having a higher carrier mobility than the second channel, and gate electride means is arranged to receive an applied voltage and in response to this to vary the distribution of the charge carriers between the plurality of channels in accordance with the applied voltage.

A particular example and modifications of a field effect transistor in accordance with this invention will now be described with reference to the accompanying drawings, in which:—

Figure 1 is a sectional elevation of the example;

Figure 2 is a sectional perspective view illustrating the operation of the example;

Figure 3 is a graph illustrating the potential distribution in the two channels of the field effect transistor under three different bias conditions; and,

Figure 4 is a graph showing the conductance-gate voltage characteristic of a modulation-mobility field effect transistor.

In the following, while an example of the mobility-modulation FET having a dual-channel structure comprising gallium arsenide (hereinafter called GaAs) and gallium aluminum arsenide (hereinafter called GaAlAs), respectively, having different mobilities is described, it will be needless to say that a mobility-modulation FET of a multichannel structure having different carrier mobilities can be realized. In this dual-channel mobility-modulation FET, first of all, an $N^+$GaAs layer 2 with resistivity 0.01 Ω · cm and thickness 1 μm is formed as a lower gate electrode on a semiinsulating GaAs substrate 1 with specific resistance $10^6$ Ω · cm by molecular beam epitaxy (MBE) method, on which a multilayer structure consisting sequentially of a GaAlAs layer 3 which is an insulating layer of thickness 0.06 μm having silicon Si of $5 \times 10^{17}$ cm$^{-3}$ doped as an impurity, a GaAs layer 4 of thickness 0.02 μm having silicon Si of $3 \times 10^{16}$ cm$^{-3}$ and beryllium Be of $3.1 \times 10^{16}$ cm$^{-3}$ doped as impurities a high-purity P-type GaAs layer 5 of acceptor density $5 \times 10^{14}$ cm$^{-3}$ or lower and thickness 0.02 μm, a GaAlAs layer 6 which is an insulating layer of thickness 0.06 μm having silicon Si of $5 \times 10^{17}$ cm$^{-3}$ doped as an impurity, and an aluminum metal thin film 7 of thickness 0.2 μm as an upper gate electrode, is formed by MBE method, and then a source electrode 8 and a drain electrode 9 are successively formed using common photolithography. Each of the numerical values showing the impurity concentrations should be understood not only to indicate strictly the value but also to include values approximate thereto in the extent known to any person skilled in the art.

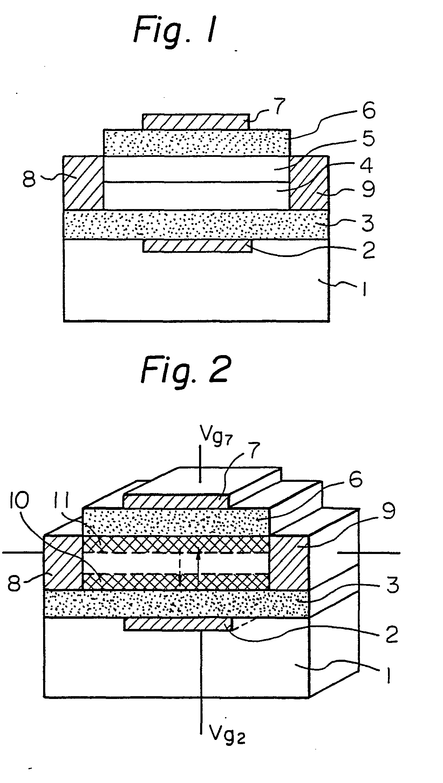

Fig. 2 is a perspective viiew showing function of the mobility-modulation FET according to the present invention. A low mobility n-type conduction channel 10 containing much impurities is formed along the interface between the GaAlAs layer 3 and the GaAs layer 4, and a high-mobility upper conduction channel 11 containing less impurities is formed along the interface between the GaAlAs layer 6 and the GaAs layer 5. Within the upper conduction channel 11, the carrier mobility reaches $10^5$ cm$^2$/V·S at liquid nitrogen temperature 77°K and, on the other hand, the mobility within the lower conduction channel 10 is as low as approximately $5 \times 10^3$ cm$^2$/v·S. It will be easily understood that the conductivity between the source electrode 8 and the drain electrode is determined by the sum of the conductivities of said two channels.

Now, the operation of this embodiment will be described with reference to the case where signal voltages $V_{g2}$ and $V_{g7}$ are applied to the gate electrodes 2 and 7, respectively.

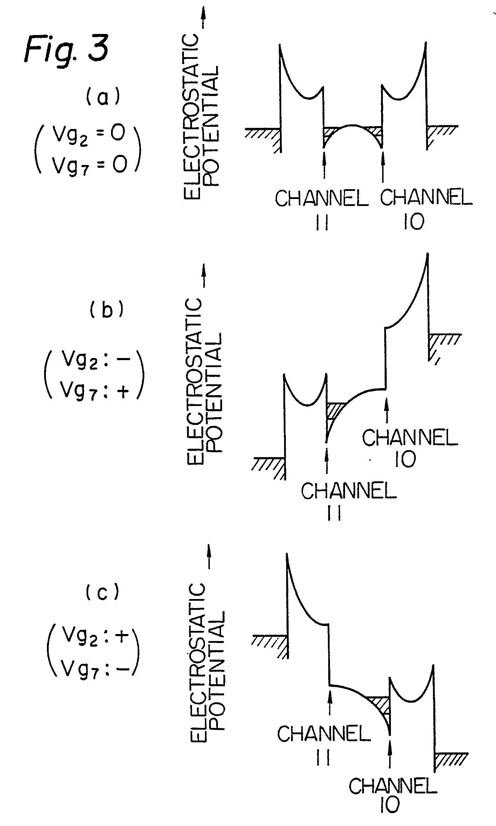

Figs. 3(a) to 3(b) are graphs showing distributions of electrostatic potentials and electrons within the two channels under respective bias conditions. As shown in Fig. 3(a), in the case where the voltage $V_{g2}$ applied to the lower gate electrode 2 and the voltage $V_{g7}$ applied to the upper gate electrode 7 are both zero, the carrier densities within the lower channel 10 and the upper channel 11, respectively, are substantially equal ($\sim 4 \times 10^{11}$/cm$^2$). Then, in the case where a positive voltage is applied to the upper gate electrode 7 while a negative voltage is applied to the lower gate electrode 2, potentials are distributed as shown in Fig. 3(b), that is, the carriers within the lower channel 10 of low mobility move into the upper channel 11 of high mobility, as shown by a solid line. As a result, the carriers moving within the channel of low mobility pass into a high mobility state so that the average mobility of the carriers increases. Then, in the case where the polarities of the voltages applied to the gate electrodes are reversed, that is, a negative voltage is applied to the upper gate electrode 7 while a positive voltage is applied to the lower gate electrode 2, the potentials are distributed as shown in Fig. 3(c), that is the carriers move from the high-mobility upper channel 11 into the low-mobility lower channel 10. Accordingly, the average carrier mobility decreases.

In brief, in the FET of the construction shown in Fig. 1, the average mobility of the carriers can be changed without changing the carrier density by controlling polarities of the voltages applied to the gate electrodes 2 and 7. Since the conductance of the channels of the FET is proportional to the product of the carrier density and velocity, that is the value of the carrier density×mobility, the conduction changes in response to the change of the mobility described above. Accordingly, the output current between the source- drain terminals changes in response to the voltages applied to the gate electrodes 2 and 7, and the construction shown in Fig. 1 functions as the FET based on a new operational principle.

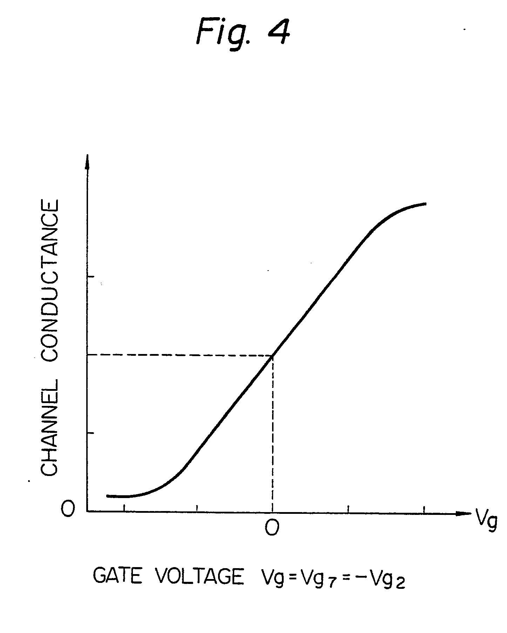

Fig. 4 is a graph showing the conductivity-gate voltage characteristic of the mobility-modulation FET according to the present invention. It is understood from Fig. 4 that the channel conductance is substantially linearly dependent on the gate voltage, showing a very excellent characteristic. The FET according to the present invention operates as an FET if only the carriers are movable between the upper channel and the lower channel without the necessity of changing the carrier density. Since the average distance between the two channels in this embodiment is of the order of 0.03 μm, the time period required for a carrier to traverse the distance between the channels can be reduced to a fraction of 1 picosecond which is the minimum of the channel transit time. Accordingly, in the FET according to the present invention, the minimum response time can be reduced to a fraction of that of the conventional FET.

With reference to this embodiment, the FET device of the system in which electrons move between spatially separated channels having mobilities was described hereinabove and a method of changing the impurity contents to make the channel mobilities different from each other was explained. Other methods for changing the mobilities in the upper and lower channels are to form channels utilizing different kinds of semiconductor materials having different mobilities from each other and to introduce impurity atoms having a function to capture carriers into the lower channel only so as to prevent the conductance in said channel by the carrier capturing function. Particularly, the latter method has an advantage that the carrier mobility in the channel into which the capturing impurity was introduced can be reduced to almost zero.

## Claims

1. A mobility-modulation field effect transistor having a source (8) and a drain (9) with conduction channel means (10, 11) for carrying charge carriers extending between them, and gate electrode means (2, 7), the conduction channel means having a multilayer structure formed from a plurality of semiconductor materials (3, 4, 5, 6) and including a plurality of channels (10, 11), the plurality of channels having different carrier mobilities and comprising a first channel (11) having less impurities than a second channel (10), accordingly the first channel (11) having a higher carrier mobility than the second channel (10); and the gate electrode means (2, 7) being arranged to receive an applied voltage and in response to this to vary the distribution of the charge carriers between the plurality of channels (10, 11) in accordance with the applied voltage.

2. A mobility-modulation field-effect transistor according to claim 1, in which an impurity capable of capturing and localizing carriers is introduced into one of the plurality of channels to make the carrier mobility of the said one channel nearly zero.

3. A mobility-modulation field effect transistor according to claim 1 or 2, in which the gate electrode means comprises two electrodes (2, 7) located on opposite sides of the plurality of semiconductor materials (3, 4, 5, 6).

**Patentansprüche**

1. Feldeffekt-Transistor mit modulierter Beweglichkeit, gekennzeichnet durch eine Quelle (8) und eine Senke (9) mit sich dazwischen erstreckenden Leitungskanalmitteln (11, 12) zum Tragen von Ladungsträgern und Gatterelektrodenmittel (2, 7), wobei die Leitungskanalmittel eine Mehrschichtstruktur aufweisen, die durch eine Vielzahl von Halbleiterwerkstoffen (3, 4, 5, 6) gebildet wird und eine Vielzahl von Kanälen (10, 11) aufweist, wobei die Vielzahl von Kanälen verschiedene Trägerbeweglichkeiten aufweist und einen ersten Kanal mit weniger Verunreinigungen aufweist als einen zweiten Kanal (10), wobei entsprechend der erste Kanal (11) eine höhere Trägerbeweglichkeit aufweist als der zweite Kanal, und wobei die Gatterelektrodenmittel eine aufgebrachte Spannung aufnehmen und als Reaktion darauf die Verteilung der Ladungsträger zwischen der Vielzahl von Kanälen (10, 11) gemäß der aufgebrachten Spannung verändern.

2. Feldeffekt-Transistor nach Anspruch 1, dadurch gekennzeichnet, daß eine Verunreinigung, die Träger festhalten und lokalisieren kann, in einen der Vielzahl von Kanälen eingebracht wird, um die Trägerbeweglichkeit des Kanals nahe null einzustellen.

3. Feldeffekt-Transistor nach Anspruch 1 oder 2, dadurch gekennzeichnet, daß die Gatterelektrodenmittel zwei Elektroden (2, 7) aufweisen, die auf entgegengesetzten Seiten der Vielzahl von Halbleiterwerkstoffen (3, 4, 5, 6) angeordnet sind.

**Revendications**

1. Un transistor à effet de champ à modulation de mobilité comprenant une source (8) et un drain (9) entre lesquels s'étend une structure de canaux de conduction (10, 11) pour transporter des porteurs de charge, et une structure d'électrodes de grille (2, 7), la structure de canaux de conduction ayant une configuration multicouche qui est formée par un ensemble de matériaux semiconducteurs (3, 4, 5, 6) et comprenant un ensemble de canaux (10, 11), l'ensemble de canaux ayant des mobilités de porteurs différentes et comprenant un premier canal (11) contenant moins d'impuretés qu'un second canal (10), ce qui fait que le premier canal (11) a une mobilité des porteurs plus élevée que celle du second canal (10); et la structure d'électrodes de grille (2, 7) étant conçue de façon à recevoir une tension appliquée et à faire varier en réponse la distribution des porteurs de charge entre l'ensemble de canaux (10, 11), conformément à la tension appliquée.

2. Un transistor à effet de champ à modulation de mobilité selon la revendication 1, dans lequel une impureté capable de capturer et de fixer des porteurs est introduite dans l'un des canaux de l'ensemble de canaux, pour faire en sorte que la mobilité des porteurs de ce canal soit presque égale à zéro.

3. Un transistor à effet de champ à modulation de mobilité selon la revendication 1 ou 2, dans lequel la structure d'électrodes de grille comprend deux électrodes (2, 7) qui sont placées sur des faces opposées de l'ensemble de matériaux semiconducteurs (3, 4, 5, 6).

## Fig. 1

## Fig. 2

# Fig. 3

(a)

$$\left( \begin{array}{c} Vg_2 = 0 \\ Vg_7 = 0 \end{array} \right)$$

ELECTROSTATIC POTENTIAL →

CHANNEL 11   CHANNEL 10

(b)

$$\left( \begin{array}{c} Vg_2 : - \\ Vg_7 : + \end{array} \right)$$

ELECTROSTATIC POTENTIAL →

CHANNEL 10

CHANNEL 11

(c)

$$\left( \begin{array}{c} Vg_2 : + \\ Vg_7 : - \end{array} \right)$$

ELECTROSTATIC POTENTIAL →

CHANNEL 11

CHANNEL 10

# Fig. 4

GATE VOLTAGE $Vg = Vg_7 = -Vg_2$